(19) Europäisches Patentamt
European Patent Office
Office européen des brevets

(11) EP 4 674 618 A1

(12) # EUROPEAN PATENT APPLICATION
published in accordance with Art. 153(4) EPC

(43) Date of publication:
**07.01.2026 Bulletin 2026/02**

(21) Application number: **24900725.3**

(22) Date of filing: **09.12.2024**

(51) International Patent Classification (IPC):
***B32B 15/082*** *(2006.01)* ***B05D 1/04*** *(2006.01)*
***B05D 7/14*** *(2006.01)* ***B05D 7/24*** *(2006.01)*
***C08F 14/26*** *(2006.01)* ***C08F 14/28*** *(2006.01)*
***C08F 16/24*** *(2006.01)* ***C08L 27/12*** *(2006.01)*
***C08L 79/08*** *(2006.01)* ***C08L 81/02*** *(2006.01)*
***C08L 81/06*** *(2006.01)* ***H05K 1/03*** *(2006.01)*

(52) Cooperative Patent Classification (CPC):
**B05D 1/04; B05D 7/14; B05D 7/24; B32B 15/082; B32B 15/20; C08F 14/26; C08F 14/28; C08F 16/24; C08L 27/12; C08L 79/08; C08L 81/02; C08L 81/06; C09D 5/44; C09D 127/12; C09D 179/08;** (Cont.)

(86) International application number:
**PCT/JP2024/043352**

(87) International publication number:
**WO 2025/121433 (12.06.2025 Gazette 2025/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.12.2023 JP 2023207536**

(71) Applicant: **Daikin Industries, Ltd.**
**Osaka-shi, Osaka 530-0001 (JP)**

(72) Inventors:
- **NAKATANI, Yasukazu**
  **Osaka-shi, Osaka 530-0001 (JP)**
- **OGINO, Ryoko**
  **Osaka-shi, Osaka 530-0001 (JP)**
- **IMADA, Hirotake**
  **Osaka-shi, Osaka 530-0001 (JP)**
- **OGITA, Koichiro**
  **Osaka-shi, Osaka 530-0001 (JP)**

(74) Representative: **Goddar, Heinz J.**
**Boehmert & Boehmert**
**Anwaltspartnerschaft mbB**
**Pettenkoferstrasse 22**
**80336 München (DE)**

(54) **LAMINATE AND METHOD FOR FORMING LAMINATE**

(57) A laminate excellent in adhesion between a substrate containing copper and a perfluoropolymer coating film is provided. A method of forming such a laminate excellent in adhesion is also provided.

The laminate includes a substrate containing copper and a coating film containing perfluoropolymer, having an adhesion strength between the substrate and the coating film of 0.2 N/mm or more, and a surface roughness of the coating film of less than 15 μm.

EP 4 674 618 A1

(52) Cooperative Patent Classification (CPC): (Cont.)
**C09D 181/02; C09D 181/06; H01B 5/00;
H01B 5/02; H05K 1/03**

## Description

### Technical Field

The present disclosure relates to a laminate and a method of forming a laminate.

### Background Art

In general, by utilizing the excellent insulating properties, heat resistance, chemical resistance, flame retardance, etc., of fluororesins, a perfluoropolymer has been widely used as a coating material on a metal substrate, in particular.

For example, in Patent Literature 1, an insulating electric wire having an insulating layer of fluororesin formed by extrusion coating onto a copper conductor for use in motor coils is described.

Further, a busbar having an insulating layer formed by electrostatically applying a powder coating material made of thermosetting resin such as epoxy resin onto a copper conductor is known (Patent Literature 2, etc.).

### Citation List

### Patent Literature

Patent Literature 1: Japanese Patent Laid-Open No. 2009-245857
Patent Literature 2: Japanese Patent Laid-Open No. 2020-35575

### Summary of Invention

### Technical Problem

An object of the present disclosure is to provide a laminate excellent in adhesion between a substrate containing copper and a perfluoropolymer coating film. Another object of the present disclosure is to provide a method of forming such a laminate excellent in adhesion.

### Solution to Problem

The present disclosure relates to a laminate including a substrate containing copper and a coating film containing perfluoropolymer, having an adhesion strength between the substrate and the coating film of 0.2 N/mm or more, and a surface roughness of the coating film of less than 15 μm.

It is preferable that the perfluoropolymer be a copolymer containing a tetrafluoroethylene (TFE) unit and at least one selected from the group consisting of a perfluoroalkyl vinyl ether (PAVE) unit and a hexafluoropropylene (HFP) unit.

It is preferable that the perfluoropolymer be a TFE/HFP copolymer.

It is preferable that the adhesion strength between the substrate and the coating film be 0.2 N/mm or more and 1.2 N/mm or less, and the surface roughness of the coating film be 0.1 μm or more and less than 1.5 μm.

The present disclosure relates also to a method of forming a laminate including applying a primer composition onto a copper-containing substrate, then applying a perfluoropolymer-containing powder composition thereon by electrostatic coating, and heating the coating to a temperature equal to or more than the melting point of the perfluoropolymer to achieve film deposition.

In the method of forming a laminate, it is preferable that the film deposition be achieved by heating the coating under oxygen-free atmosphere to a temperature equal to or more than the melting point of the perfluoropolymer.

In the method of forming a laminate, it is also preferable that the film deposition be achieved by applying a powder composition that contains a perfluoropolymer having a melting point of less than 310°C by electrostatic coating, and heating the coating under oxygen-free atmosphere to a temperature equal to or more than the melting point of the perfluoropolymer and less than 320°C.

The present disclosure relates also to a method of forming a laminate including applying a powder composition that contains a perfluoropolymer having a melting point of less than 310°C onto a copper-containing substrate by electrostatic coating, and heating the coating to a temperature equal to or more than the melting point of the perfluoropolymer and less than 320°C to achieve film deposition.

In the method of forming a laminate, it is preferable that the film deposition be achieved by heating the coating

under oxygen-free atmosphere to a temperature equal to or more than the melting point of the perfluoropolymer and less than 320°C.

The present disclosure relates also to a method of forming a laminate including applying a perfluoropolymer-containing powder composition onto a copper-containing substrate by electrostatic coating, and heating the coating to a temperature equal to or more than the melting point of the perfluoropolymer under oxygen-free atmosphere to achieve film deposition.

It is preferable that two or more of the methods of forming a laminate described above be used in combination.

In the method of forming a laminate, it is preferable that the perfluoropolymer be a copolymer containing a tetrafluoroethylene (TFE) unit and at least one selected from the group consisting of a perfluoroalkyl vinyl ether (PAVE) unit and a hexafluoropropylene (HFP) unit.

In the method of forming a laminate, it is preferable that the primer composition contain a perfluoropolymer as essential component and one or more resins selected from the group consisting of polyamide imide, polyether sulfone, and polyarylene sulfide.

The present disclosure relates also to a laminate formed by any of the methods of forming a laminate described above.

In the laminate formed by any of the methods of forming a laminate described above, it is preferable that the perfluoropolymer be a TFE/HFP copolymer.

The present disclosure relates also to an article having the laminate described above.

The present disclosure relates also to a magnet wire having the laminate described above.

The present disclosure relates also to a busbar having the laminate described above.

The present disclosure relates also to a high frequency circuit board having the laminate described above.

Advantageous Effects of Invention

The laminate of the present disclosure is excellent in the adhesion between a copper-containing substrate and a perfluoropolymer coating film.

Further, the method of forming a laminate of the present disclosure can provide a laminate excellent in the adhesion between a copper-containing substrate and a perfluoropolymer coating film.

Brief Description of Drawing

[Figure 1] Figure 1 is a schematic diagram showing the state of a coating film in measurement of adhesion strength between the coating film and a substrate in Example.

Description of Embodiments

The present disclosure is described in detail as follows.

It is expected that a laminate including a perfluoropolymer coating film excellent in insulating properties formed on a substrate such as copper and copper alloy is utilized for a magnet wire, a busbar, a high frequency circuit board, etc.

As a method of forming the laminate, a method of forming a coating film of perfluoropolymer-containing extruded composition on a long copper substrate is known. However, such a laminate does not have a sufficient adhesion between a substrate and a coating film, and has problems of occurrence of peeling or cracks of the coating film and occurrence of non-uniform film thickness in bending, which remain to be solved.

On the other hand, a conceivable method includes forming a perfluoropolymer coating film from a perfluoropolymer-containing powder composition on a copper substrate surface by electrostatic coating. Such a powder coating is advantageous over extrusion coating in terms of forming a good coating film on a substrate having a complex shape as well. However, it is difficult to secure sufficient adhesion between a copper substrate and a perfluoropolymer coating film.

The present disclosure can provide a laminate excellent in adhesion, by forming a laminate having a perfluoropolymer coating film on a copper-containing substrate according to at least one or more methods of the following items (1) to (3). Further, the laminate of the present disclosure is excellent in surface smoothness.

(1) On a copper-containing substrate, a primer composition is coated, then a perfluoropolymer-containing powder composition is applied thereto by electrostatic coating, and the coating is heated to a temperature equal to or more than the melting point of the perfluoropolymer to achieve film deposition.

(2) On a copper-containing substrate, a powder composition that contains a perfluoropolymer having a melting point of less than 310°C is applied by electrostatic coating, and the coating is heated to a temperature equal to or more than the melting point of the perfluoropolymer and less than 320°C to achieve film deposition.

(3) On a copper-containing substrate, a perfluoropolymer-containing powder composition is applied by electrostatic

coating, and the coating is heated to a temperature equal to or more than the melting point of the perfluoropolymer under oxygen-free atmosphere to achieve film deposition.

According to the method of forming a laminate as described above, a laminate having an adhesion strength between the copper-containing substrate and the coating film of 0.2 N/mm or more and a surface roughness of the coating film of less than 15 μm can be obtained.
The laminate exhibits particularly excellent performance when used for a magnet wire, a busbar, a high frequency circuit board, etc., having a copper-containing conductor as substrate.

(Laminate)

The laminate of the present disclosure includes a copper-containing substrate and a perfluoropolymer-containing coating film, having an adhesion strength between the substrate and the coating film of 0.2 N/mm or more, and a surface roughness of the coating film of less than 15 μm.
The laminate of the present disclosure has an adhesion strength between the substrate and the coating film of 0.2 N/mm or more. Due to having an adhesion strength of 0.2 N/mm or more, the laminate subjected to bending has no problems of occurrence of peeling or cracks of the coating film and occurrence of non-uniform film thickness.
The adhesion strength between the substrate and the coating film is preferably 0.3 N/mm or more, and more preferably 0.4 N/mm or more. The upper limit of the adhesion strength is not limited. An adhesion strength of 1.2 N/mm or less is sufficient, and even with an adhesion strength of 1.0 N/mm or less, the effects required in the present disclosure can be sufficiently exhibited.
In the present specification, the adhesion strength is a value obtained by the measurement method of the adhesion strength in the following Examples.
It is noted that, in the method of forming a laminate according to the item (1) described above, where a primer film is coated on the substrate surface in advance and then a coating film of perfluoropolymer-containing powder composition is disposed, the adhesion strength means the adhesion strength between the substrate and the primer film.
It is preferable that the surface roughness of the coating film be less than 1.5 μm. Due to having a surface roughness of less than 1.5 μm, an advantage in terms of exhibiting good electrical characteristics can be achieved.
The surface roughness of the coating film is preferably 1.0 μm or less, and more preferably 0.7 μm or less. The lower limit of the surface roughness is not limited, and preferably 0.01 μm or more and more preferably 0.1 μm or more.
In the present specification, the surface roughness is a value obtained by the measurement method of surface roughness in Examples described below.
A surface roughness of the coating film of less than 1.5 μm can be achieved, for example, by heating at a temperature more than the melting point of the perfluoropolymer by 20°C or more for 20 minutes or more.

(Substrate)

The substrate for use in the laminate of the present disclosure contains copper, and examples thereof include an elemental copper metal and copper alloys. Examples of the elemental copper metal include a tough pitch copper and an oxygen-free copper. Further examples include a composite copper including a minute amount of aluminum, nickel, silver or the like, and a clad material of copper and aluminum. It is preferable that the substrate for use in the laminate of the present disclosure be an elemental copper metal.
The substrate may be subjected to surface treatment such as washing and sand blasting on an as needed basis.
A substrate subjected to surface roughening has an increased anchoring effect on the powder composition for use in forming the coating film, so that the adhesion to the coating film can be further improved.

(Perfluoropolymer)

The perfluoropolymer contained in the coating film of the laminate of the present disclosure is not limited, and any known one may be used. Examples of the perfluoropolymer include one that is obtained by polymerizing one or more monomer components such as perfluoromonomers such as tetrafluoroethylene (TFE), hexafluoropropylene (HFP), and perfluoro(alkyl vinyl ether) (PAVE).
The PAVE is not limited, and examples thereof include one or more such as perfluoromethyl vinyl ether (PMVE), perfluoro ethyl vinyl ether (PEVE), and perfluoropropyl vinyl ether (PPVE). In particular, perfluoropropyl vinyl ether (PPVE) is preferred.
Among these, it is preferable that the perfluoropolymer be a copolymer including a tetrafluoroethylene unit as essential component and at least one selected from the group consisting of a perfluoroalkyl vinyl ether unit and a hexafluoro propylene unit. Alternatively, the perfluoropolymer may include two or more of the copolymers in combination.

Specifically, a TFE/PAVE copolymer (PFA), a TFE/HFP copolymer (FEP), a TFE/PAVE/HFP copolymer, and the like are preferred. In particular, a TFE/HFP copolymer and a TFE/PAVE/HFP copolymer are suitable from the viewpoint of film deposition at a relatively low temperature.

It is preferable that the melting point of the perfluoropolymer be less than 310°C. The melting point is more preferably 200°C or more and less than 310°C, and still more preferably 220°C or more and 270°C or less.

With a melting point in the range, a smooth surface can be obtained without decrease in the heat resistance.

In the present specification, the melting point is a temperature corresponding to the maximum value in the heat-of-fusion curve when the temperature is raised at a rate of 10°C/minute with a differential scanning calorimeter [DSC].

It is preferable that the MFR of the perfluoropolymer be 1 to 40 g/10 minutes.

With a melt flow rate in the range, good adhesion between layers can be achieved. Further, flowability during coating is good to achieve high surface smoothness. Furthermore, heating for a long time is not required to obtain the target smoothness of the coating film, which results in no deterioration problem of the perfluoropolymer.

The more preferable lower limit is 5 g/10 minutes, and the more preferable upper limit is 30 g/10 minutes.

In the present specification, the MFR is a value measured at a temperature of 372°C under a load of 5 kg according to ASTM D2116.

The perfluoropolymer can have an MFR within the range through adjustment of the molecular weight or the like.

The method of producing the perfluoropolymer is not limited, and the product can be obtained through copolymerization using a conventionally known polymerization method such as emulsion polymerization and suspension polymerization.

The coating film may contain a thermal stabilizer, a coloring pigment additive, etc. to be described below, in addition to a perfluoropolymer.

In the coating film, the perfluoropolymer content is preferably 70 to 100 mass%. With a perfluoropolymer content in the range, good electrical characteristics can be exhibited, which is an advantage.

The more preferable lower limit is 90 mass%, and the still more preferable lower limit is 95 mass%.

In the laminate of the present disclosure, the film thickness of the coating film is preferably 10 to 200 μm, more preferably 20 μm or more, still more preferably 30 μm or more, and more preferably 150 μm or less, still more preferably 100 μm or less.

If the film thickness is too thick, when using for a device such as motor, downsizing of the device may be difficult in some cases. Also, if the film thickness is too thin, sufficient insulating properties may not be obtained in some cases.

The relative dielectric constant of the coating film is preferably 2.1 to 2.8, and more preferably 2.6 μm or less. With a relative dielectric constant in the range, good insulating properties can be exhibited, which is an advantage.

In the present specification, the relative dielectric constant is a value obtained by a measurement method of relative dielectric constant in the following Examples.

(Method of forming laminate)

It is preferable that the method of forming a laminate of the present disclosure include applying the perfluoropolymer-containing powder composition onto a substrate by an electrostatic coating method, and heating the coating to achieve film deposition.

(Powder composition)

In the present disclosure, the powder composition for use in forming the coating film includes the perfluoropolymer powder.

It is preferable that the powder composition have an average particle size of 1 to 100 μm. With an average particle size of less than 1 μm, electrostatic repulsion is easy to occur during coating, so that a coating film tends to be hardly formed, while with an average particle size of more than 100 μm, the resulting coating film may have poor smoothness etc. in some cases.

The more preferable lower limit is 10 μm, and the more preferable upper limit is 80 μm.

The average particle size of the powder composition can be controlled in the range by adjusting the conditions for crushing and classification in the production method of the powder composition described as follows.

In the present specification, the average particle size is a value measured by laser diffraction method. Specifically, the average particle size is a volume-based median diameter measured by MT-3300II manufactured by MicrotracBEL Corp.

It is preferable that the powder composition have an apparent density of 0.5 to 1.1 g/ml. With an apparent density of less than 0.5 g/ml, electrostatic coating tends to be difficult due to occurrence of bubbling during coating, or increase in the number of coatings, while with an apparent density of more than 1.1 g/ml, industrial production of such a powder composition tends to be difficult. The lower limit of the preferable apparent density is 0.7 g/ml, and the more preferable

upper limit is 1.0 g/ml.

In the present specification, the apparent density (g/ml) is a value obtained by measurement according to JIS K 6891.

The powder composition may contain a thermal stabilizer. The powder composition containing the thermal stabilizer can prevent coloring and bubbling of the coating film caused by unstabilized perfluoropolymer when heated at a temperature equal to or more than the approximate melting point.

Preferred examples of the thermal stabilizer include at least one selected from the group consisting of an amine-type antioxidant, an organic sulfur-containing compound and a metal powder, from the viewpoint of preventing oxidation of the perfluoropolymer.

Examples of the amine-based antioxidant include an aromatic amine having an aromatic hydrocarbon group such as a phenyl group and a naphthyl group in the molecule, and examples thereof include phenylene diamine-based compounds such as N,N'-diphenyl-p-phenylene diamine, N,N'-di-2-naphthyl-p-phenylene diamine, and a reaction product between diphenyl amine and diisobutylene; and other aromatic secondary amine compounds such as dinaphthyl amine, phenyl-α-naphthyl amine, phenyl-β-naphthyl amine, 4,4'-bis(α,α'-dimethyl benzyl)diphenyl amine, phenyl cyclohexy-p-phenylene diamine, and styrenated diphenyl amine.

Examples of the organic sulfur-containing compound include a mercapto benzimidazole-based compound such as 2-mercapto benzimidazole and 2-mercapto methyl benzimidazole; a mercapto benzothiazole-based compound such as 2-mercapto benzothiazole, a cyclohexyl amine salt of 2-mercapto benzothiazole, dibenzothiazyl disulfide, 2-(4'-morpholinodithio)benzothiazole, N-cyclohexyl-2-benzothiazolyl sulfenamide, N-oxydiethylene-2-benzothiazolyl sulfenamide, and N-tert-butyl-2-benzothiazolyl sulfenamide; a mercapto imidazoline-based compound such as 2- mercapto imidazoline; and dithiocarbamic acids such as pentamethylene dithiocarbamic acid, pipecolyl dithiocarbamic acid, dimethyl dithiocarbamic acid, diethyl dithiocarbamic acid, dibutyl dithiocarbamic acid, and N-ethyl-N-phenyl dithiocarbamic acid. These may be, for example, a salt of metal such as Zn, Sn, Cd, Cu and Fe; and an organic salt such as a piperidine salt and a pipecolyl salt.

Examples of the organic sulfur-containing compound include thiuram compounds including a thiuram monosulfide such as tetramethyl thiuram monosulfide; a thiuram disulfide such as tetramethyl thiuram disulfide, tetraethyl thiuram disulfide, and tetrabutyl thiuram disulfide; and other thiuram compounds such as dipentamethylene thiuram tetrasulfide.

Alternatively, the organic sulfur-containing compounds may be, for example, thiourea derivatives such as N,N'-diethyl thiourea, dibutyl thiourea and dilauryl thiourea.

Examples of the metal powder include one or more of cobalt powder, iron powder, zinc powder, tin powder and a copper powder. It is more preferable that the metal powder be used in combination with the organic sulfur-containing compound and/or the amine-type antioxidant rather than being used alone.

Since the thermal stabilizer is required to have stability at a temperature equal to or more than the approximate melting point of the perfluoropolymer contained in the powder composition, for example, at a high temperature of about 250°C or more, an aromatic ring-containing compound is preferred, and an aromatic amine, a mercapto benzothiazole-based compound and a mercapto benzimidazole-based compound are more preferred as thermal stabilizer.

In the case of using the powder composition for a semiconductor production facility etc., it is preferable that the thermal stabilizer be a nonmetal compound that remains no metal residue.

Although the thermal stabilizer can be produced by a conventionally known method, a commercially available product may be usually used.

It is preferable that the thermal stabilizer content relative to 100 parts by mass of the perfluoropolymer be 0.001 to 5 parts by mass. With a content of less than 0.001 parts by mass, the thermal stability of the perfluoropolymer may worsen in some cases, while with a content of more than 5 parts by mass, coloring and bubbling caused by decomposition of the thermal stabilizer occur in the resulting coating film, which are undesirable. The more preferable content is 0.003 to 2 parts by mass.

The powder composition may contain a coloring pigment. Examples of the coloring pigment include titanium oxide, cobalt oxide, carbon, chromium oxide, iron oxide and mica.

It is preferable that the coloring pigment content relative to 100 parts by mass of the TFE-based copolymer be 0.001 to 5 parts by mass. With a content of less than 0.001 parts by mass, an intended coloring may not be obtained in some cases, while with a content of more than 5 parts by mass, bubbling may occur in the resulting coating film in some cases. The more preferable content is 0.003 to 2 parts by mass.

The powder composition may contain additives and the like as needed in combination with the perfluoropolymer and the stabilizer and/or coloring pigment used when desired. The additives and the like are not limited, and examples thereof include one that is used for a typical powder composition.

Examples of the additives include other pigments such as an anti-rusting pigment and a fired pigment for anti-rusting etc.; coating-reinforcing materials such as carbon fiber, glass fiber, glass flake and mica for preventing shrinkage of the coating film; and an electric conductivity imparting material such as electric conductive carbon for imparting electric

conductivity. A levelling agent, an antistatic agent or the like may be also employed.

The content of the additives relative to the powder composition is preferably 0 to 10.0 mass%, and more preferably 0 to 5.0 mass%.

The average particle size of the thermal stabilizer, coloring pigment and additives is preferably 0.1 to 70 μm, and more preferably 0.1 to 50 μm. With a particle size in the range, the particles are uniformly dispersed in the composition, so that coating can be stably performed.

The average particle size is a value measured by laser diffraction method. Specifically, the value is a volume-based median diameter measured by MT-3300II manufactured by MicrotracBEL Corp.

The powder composition for use in the present disclosure can be produced by mixing each of the components described above.

Using various crushers such as a jet mill, a hammer mill and a pin mill, or by appropriate combination thereof on an as needed basis, adjustment of the crushing conditions, adjustment of the crushing time and adjustment of proportions of resin components used in combination are performed, so that proper pulverization can be achieved.

In the method of forming a laminate of the present disclosure, it is particularly preferable that the laminate including a copper substrate and a perfluoropolymer coating film be formed by at least one or more methods described in the following items (1) to (3). The laminate formed according to such a method allows the adhesion and surface smoothness to be improved.

(1) A primer composition is coated onto a copper-containing substrate, and then the powder composition is applied by electrostatic coating and heated to a temperature equal to or more than the melting point of the perfluoropolymer to achieve film deposition.

(2) On a copper-containing substrate, the powder composition that contains a perfluoropolymer having a melting point of less than 310°C is applied by electrostatic coating, and the coating is heated to a temperature equal to or more than the melting point of the perfluoropolymer and less than 320°C to achieve film deposition.

(3) On a copper-containing substrate, the powder composition is applied by electrostatic coating, and the coating is heated to a temperature equal to or more than the melting point of the perfluoropolymer under oxygen-free atmosphere to achieve film deposition.

In the method according to the item (1), a primer film is formed on the substrate in advance. The method is suitable from the viewpoint of enhancing adhesion between the perfluoropolymer layer and the substrate by disposing a primer layer in advance in film deposition of the perfluoropolymer on the copper-containing substrate.

(Primer composition)

The primer composition for use in the method according to the item (1) is preferably the same one as the perfluoropolymer to form the coating film. In other words, a copolymer containing a tetrafluoroethylene unit, and at least one selected from the group consisting of a perfluoroalkyl vinyl ether unit and a hexafluoropropylene unit is preferred.

Specifically, a TFE/PAVE copolymer (PFA), a TFE/HFP copolymer (FEP), a TFE/PAVE/HFP copolymer, etc. are preferred.

As the primer composition, use of one or more resins selected from the group consisting of polyamide imide (PAI), polyether sulfone (PES) and polyarylene sulfide (PAS), which are heat-resistant resins is also preferred.

(Polyamide imide)

PAI is a resin composed of a polymer having an amide bond and an imide bond in the molecular structure. The PAI is not limited, and examples thereof include a resin made of high molecular polymer obtained from each reaction such as a reaction between an aromatic diamine having an amide bond in the molecule and an aromatic tetravalent carboxylic acid such as pyromellitic acid; a reaction between an aromatic trivalent carboxylic acid such as trimellitic acid anhydride and a diamine such as 4,4-diamino phenyl ether or a diisocyanate such as diphenyl methane diisocyanate; and a reaction between a dibasic acid having an aromatic imide ring in the molecule and a diamine. As the PAI, one composed of a polymer having an aromatic ring in the main chain is preferred from the viewpoint of excellence in heat resistance.

It is preferable that PAI have a glass transition temperature of 200°C or more. A glass transition temperature of 250°C or more is more preferred. With a glass transition temperature in the range, the heat resistance of the primer composition can be improved. Further, the glass transition temperature of PAS is preferably 320°C or less, more preferably 300°C or less, and still more preferably 280°C or less.

The glass transition temperature is measured by differential scanning calorimeter (DSC).

It is preferable that PAI have a melting point of 250°C or more. A melting point of 260°C or more is more preferred. With a melting point in the range, the heat resistance of the resin composition can be improved. Further, the melting point of

PAI is preferably 320°C or less, and more preferably 300°C or less.

The melting point is measured by differential scanning calorimeter (DSC).

(Polyether sulfone)

The PES is excellent in adhesion to an object to be coated, and has sufficient heat resistance even under firing temperature during formation of the coating film, allowing the resulting coating film to have excellent corrosion resistance and water vapor resistance.

PES is, for example, a resin of polymer having a repeating unit represented by the following general formula:

[Chemical Formula 1]

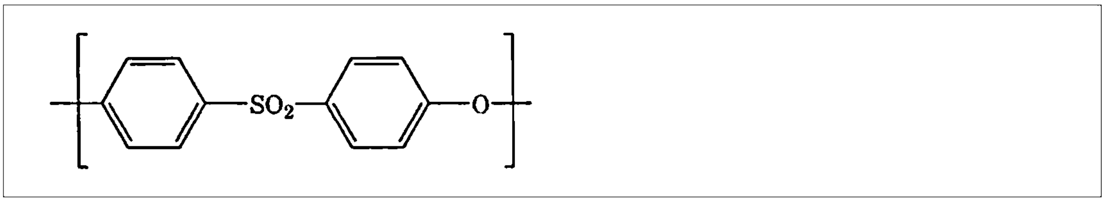

PES is not limited, and examples thereof include a resin of polymer obtained through polycondensation of dichloro diphenyl sulfone and bisphenol.

It is preferable that PES have a glass transition temperature of 200°C or more. The glass transition temperature is more preferably 205°C or more, and still more preferably 210°C or more. With a glass transition temperature in the range, the heat resistance of the primer composition can be improved. Further, the glass transition temperature of PES is preferably 250°C or less, and more preferably 240°C or less. The glass transition temperature is measured by differential scanning calorimeter (DSC).

(Polyarylene sulfide)

Examples of PAS include one having a repeating unit represented by the following general formula:

-(Ar-S)-

wherein Ar represents an arylene group and S represents sulfur. It is preferable that the content of the repeating unit in the resin be 70 mol% or more. Examples of the arylene group can include p-phenylene, m-phenylene, o-phenylene, alkyl-substituted phenylene, phenyl-substituted phenylene, halogen-substituted phenylene, amino-substituted phenylene, amide-substituted phenylene, p,p'-diphenylene sulfone, p,p'-biphenylene, and p,p'-biphenylene ether. PAS can be classified broadly into a resin having a crosslink and a branched structure (crosslink type) and a resin having substantially no crosslink and no branched structure (linear type). In the present disclosure, any of the crosslink type and the linear type can be used without problem. Preferred examples of PAS include polyphenylene sulfide.

It is preferable that the glass transition temperature of PAS be 70°C or more. The glass transition temperature is more preferably 80°C or more, and still more preferably 85°C or more. With a glass transition temperature in the range, the heat resistance of the resin composition can be improved. Further, the glass transition temperature of PAS is preferably 300°C or less, and more preferably 250°C or less. The glass transition temperature is measured by differential scanning calorimeter (DSC).

It is preferable that the melting point of PAS be 180°C or more. The melting point is more preferably 190°C or more. With a melting point in the range, the heat resistance of the resin composition can be improved. Further, the melting point of PAS is preferably 380°C or less, and more preferably 350°C or less. The melting point is measured by differential scanning calorimeter (DSC).

From the viewpoints of excellent adhesin to a substrate and formability of a coating film excellent in non-stickiness, the resin is preferably PES or PAS, and more preferably PAS. PES and PAS each may include one type or two types or more.

It is also preferable that the resin include PES or PAS and PAI. In other words, the resin may be a mixture of PAS and PAI, or a mixture of PES and PAI. From the resin containing PAI in addition to PAS or PES, a coating film excellent in secondary adhesion (adhesion to a substrate after repetition of heating and cooling of the coating film) can be obtained. It is more preferable that the resin include PAS and PAI, i.e., be a mixture of PAS and PAI. PAS, PES and PAI each may include one type or two types or more.

In the case where the resin includes PAS or PES and PAI, it is preferable that the PAS or PES content be 20 to 80 mass% relative to the total amount of the PAS or PES and PAI. The content is more preferably 30 to 70 mass%.

In the composition, the mass ratio between the perfluoropolymer and the resin (perfluoropolymer/resin) is preferably 5/95 to 95/5, more preferably 10/90 to 90/10, and still more preferably 50/50 to 85/15.

With a mass ratio between the fluororesin and the heat-resistant resin in the range, each of the adhesive strength between the perfluoropolymer layer and the primer layer and the adhesive strength between the primer layer and the substrate can be enhanced.

The primer composition may appropriately contain other additives.

The primer composition is preferably a powder composition, and in the same manner as in film deposition of a perfluoropolymer, it is preferable that the primer layer be coated through electrostatic coating and heating to achieve film deposition. In the formation of the primer layer also, the methods according to the item (2) and/or (3) are preferred.

It is preferable that the film thickness of the primer film be 10 to 100 μm. The film thickness is more preferably 20 to 80 μm. With a film thickness of the primer film in the range, the good adhesive strength between the perfluoropolymer layer and the substrate can be exhibited, which is an advantage.

On the primer film, the powder composition can be applied by electrostatic coating, and fired by heating to form a coating film.

The electrostatic coating is not limited, and may be performed by a conventional method.

It is preferable that the heating temperature be a temperature equal to or more than the melting point of perfluoropolymer. Specifically, the heating temperature is preferably equal to or more than the melting point + 20°C. The upper limit of the heating temperature may be less than 320°C from the viewpoint of suppressing oxidation of the substrate and deterioration of the coating film.

The heating time is preferably 5 minutes or more, and more preferably 10 minutes or more. The upper limit of the heating time may be 60 minutes or less from the viewpoint of suppressing oxidation of the substrate and deterioration of the coating film.

As described above, the method described in the item (2) includes applying the powder composition containing a perfluoropolymer having a melting point of less than 310°C onto a substrate by electrostatic coating, and heating the coating to a temperature equal to or more than the melting point of the perfluoropolymer and less than 320°C to achieve film deposition.

In the case where a coating film of powder composition containing perfluoropolymer is formed on the surface of a copper-containing substrate, heating the powder composition in a temperature region at 320°C or more makes it easy to accelerate oxidation of copper, so that the adhesion between the copper substrate and the perfluoropolymer coating film may be damaged in some cases.

Therefore, in the method described in the item (2), heating is performed at a temperature of less than 320°C to suppress oxidation of copper, so that good adhesion between the copper substrate and the perfluoropolymer coating film can be achieved.

It is preferable that the heating temperature be less than 300°C.

The method described in the item (3) includes applying a powder composition by electrostatic coating, and heating the coating to a temperature equal to or more than the melting point of the perfluoropolymer under oxygen-free atmosphere.

Since the heating is performed under oxygen-free atmosphere, oxidation of the substrate or formation of a brittle oxide layer can be suppressed, so that adhesion to the substrate is improved.

The method for heating under oxygen-free atmosphere includes heating in an inert gas that contains no more than 1 mass% of oxygen gas. Examples of the inert gas include nitrogen gas.

In the method according to the item (3), it is preferable that the heating temperature and the heating time be the same as in the method according to the item (1).

Among the methods according to the items (1) to (3), a combination use of the methods according to the items (1), (2) and (3) is particularly preferred. A combination use of the methods according to the items (1) and (3), or a combination use of the methods according to the items (2) and (3) is also preferred. Through the combination use of the two methods also, formation of an oxidized coating film can be suppressed, and use of the primer composition allows good adhesion to a copper substrate to be achieved.

Through the method of forming a laminate described above, a laminate excellent in adhesion and surface smoothness can be obtained.

The present disclosure relates also to a method of forming a laminate including applying a primer composition on a copper-containing substrate, then applying the powder composition thereto by electrostatic coating, and heating the coating to a temperature equal to or more than the melting point of the perfluoropolymer to achieve film deposition.

Further, the present disclosure relates also to a method of forming a laminate including applying the powder composition that contains a perfluoropolymer having a melting point of less than 310°C onto a copper-containing substrate by electrostatic coating, and heating the coating to a temperature equal to or more than the melting point of the

perfluoropolymer and less than 320°C to achieve film deposition.

Further, the present disclosure relates also to a method of forming a laminate including applying the powder composition onto a copper-containing substrate by electrostatic coating, and heating the coating to a temperature equal to or more than the melting point of the perfluoropolymer under oxygen-free atmosphere to achieve film deposition.

A single or combination use of the methods according to the items (1) to (3) allows a laminate excellent in adhesion and surface smoothness to be obtained.

A combination use of two or more of the methods according to the items (1) to (3) is preferred. Specifically, as described above, a combination use of the methods according to the items (1) and (3), or a combination use of the methods according to the items (2) and (3) is preferred. A combination use of the methods according to the items (1), (2) and (3) is particularly preferred.

The present disclosure relates also to an article having the laminate.

Specifically, the laminate of the present disclosure is suitably used for, for example, articles such as a magnet wire, a busbar, and a high frequency circuit board.

As the conductor of these articles, copper and copper alloy are usually used, so that the laminate of the present disclosure is suitably used.

The present disclosure relates also to a magnet wire having the laminate of the present disclosure.

The magnet wire is used for coils or the like of a motor and a transformer. Examples of the motor include a motor for electric automobiles, a compressor motor for an air conditioner or a refrigerator, and a sealed motor.

The present disclosure relates also to a busbar having the laminate of the present disclosure.

A busbar is used as a wiring member for electric automobiles or for transmitting electric current in a power conversion device such as an inverter and a converter.

A busbar is used also in a switch board (cubicle), a control panel and a battery, capable of conducting a large capacity current.

Due to having a small electrical resistance, a busbar is able to efficiently supply a large capacity current to each part. In addition, since wiring operation is completed by fixing a busbar with a screw only, even in a switch board or a control panel being large in size, a large capacity power source can be branched over a whole board or panel in a relatively simple way. Based on these characteristics, a busbar is widely used instead of a cable or a conducting wire. For example, in a battery module having a plurality of batteries, a terminal of one battery and a terminal of another battery are electrically connected through a busbar.

The laminate of the present disclosure is suitably used as a substrate for circuits.

The substrate for circuits is a plate-shaped component that electrically connects electronic components such as semiconductors and capacitor chips, and concurrently, disposes and fixes the electronic components in a limited space. The structure of the substrate for circuits formed from the laminate of the present disclosure is not limited. The substrate for circuits may be any of a rigid substrate, a flexible substrate, and a rigid-flexible substrate. The substrate for circuits may be any of a single-sided substrate, a double-sided substrate, and a multi-layer substrate (build-up substrate or the like).

In particular, the laminate can be suitably used for a flexible substrate and a rigid substrate. In particular, the laminate can be suitably used as a substrate for a high frequency of 10 GHz or more.

The present disclosure relates also to a high frequency circuit board having the laminate of the present disclosure.

The high frequency circuit in the present disclosure includes not only one including a circuit for transmitting high-frequency signals only, but also a circuit including a transmission path for transmitting non-high-frequency signals attached on the same plane, such as a transmission path in which high-frequency signals are converted into low-frequency signals and the low-frequency signals formed are outputted outside, and a transmission path for supplying electric power for driving a component corresponding to high-frequencies.

The high frequency circuit board of the present disclosure can be suitably used for a mobile communication terminals such as a mobile phone, a smartphone, and a tablet terminal, communication equipment such as Wi-Fi equipment, a surface acoustic wave (SAW) device, and a radar component. Further, the high frequency circuit board of the present disclosure can be used also as a circuit substrate of an antenna and a filter.

The substrate for circuits can be produced from the laminate described above by a typical method.

## Examples

The present invention is specifically described with reference to Examples as follows, though the present invention is not limited to these Examples. Herein, "%" and "parts" in Tables represent "mass%" and "parts by mass", respectively.

The various properties shown in Examples were measured by the following methods.

Film thickness of coating film

The film thickness of the coating film was measured by a film thickness meter LZ-373 manufactured by Kett Electric Laboratory Co. Ltd.

Surface roughness of coating film

The surface roughness Ra of the coating film was measured by a surface roughness measuring instrument Surtronic DUOII manufactured by Taylor Hobson.

Adhesion strength between coating film and substrate

The adhesion strength between a coating film and a substrate was measured by AGS-J Autograph (50N) manufactured by SHIMADZU CORPORATION. As shown in Figure 1, on the coating film of a laminate, two notches with a length of 50 mm were made in approximately parallel in a long axis direction, and at both ends thereof, one notch was made in a short axis direction, at right angle to the coating film. The notched coating film was peeled to a length of 10 mm on one end to be gripped in an upper chuck (not shown in the figure). The substrate was fixed to the lower part to horizontalize the long face direction.

Using a jig interlinkingly moving in the lateral direction corresponding to the travel distance in the vertical direction along with moving of the device in the tensile direction, the angle was adjusted such that the peeled coating film was always vertical to the substrate in the long face direction. The tensile stress during pulling at a rate of 100 mm/min until peeling to a length of 30 mm was measured, and the maximum point stress was defined as the adhesion strength.

Relative dielectric constant of coating film

The electrostatic capacity was obtained by an LCR high tester 3522-50 manufactured by HIOKI E.E. CORPORATION, and the relative dielectric constant was calculated from the following formula:

$$C=Ca+Cb$$

wherein C is the electrostatic capacity per unit length of a coating film (pf/m), which is a synthesis of the electrostatic capacity Ca of a flat part and the electrostatic capacity Cb of each bent part.

$$Ca=(\varepsilon/\varepsilon_0)\times 2\times (L_1+L_2)/T$$

$$Cb=(\varepsilon/\varepsilon_0)\times 2\pi\varepsilon_0/Log\{(r+T)/r\}/r$$

wherein $\varepsilon_0$ is the dielectric constant of vacuum, $L_1$ is the long side of a copper plate, $L_2$ is the short side of a copper plate, and T is a thickness of the coating film.

Comparative Example 1

On a copper plate (thickness: 1 mm), perfluoropolymer powder A (TFE/PPVE copolymer, melting point: 301°C) was electrostatically applied, and the coating was heated in a drying oven under oxygen atmosphere at 350°C for 30 minutes to obtain a coating film. The properties of the coating film were evaluated.

Example 1

On a copper plate, PFA primer A (PFA/polyamide imide/polyarylene sulfide=80/10/10 (mass%)) was applied by electrostatic coating, and the coating was heated in a drying oven under oxygen atmosphere at 350°C for 30 minutes to obtain a coating film. Further, perfluoropolymer powder A was applied by electrostatic coating, and the coating was heated in a drying oven under oxygen atmosphere at 350°C for 30 minutes to obtain a coating film. The properties of the coating film were evaluated.

Example 2

On a copper plate, perfluoropolymer powder A was applied by electrostatic coating, and the coating was heated

in a drying oven under nitrogen-purged oxygen-free atmosphere at 350°C for 30 minutes to obtain a coating film. The properties of the coating film were evaluated.

Example 3

On a copper plate, PFA primer A was applied by electrostatic coating, and the coating was heated in a drying oven under nitrogen-purged oxygen-free atmosphere at 350°C for 30 minutes to obtain a coating film. Further, perfluoropolymer powder A was applied by electrostatic coating, and the coating was heated in a drying oven under oxygen-free atmosphere at 350°C for 30 minutes to obtain a coating film. The properties of the coating film were evaluated.

Comparative Example 2

On a copper plate, perfluoropolymer powder B (TFE/HFP copolymer, melting point: 269°C) was applied by electrostatic coating, and the coating was heated in a drying oven under oxygen atmosphere at 320°C for 30 minutes to obtain a coating film. The properties of the coating film were evaluated.

Example 4

On a copper plate, FEP primer B (FEP/polyether sulfone=80/20 (mass%)) was applied by electrostatic coating, and the coating was heated in a drying oven under oxygen atmosphere at 320°C for 30 minutes to obtain a coating film. Further, perfluoropolymer powder B was applied by electrostatic coating, and the coating was heated in a drying oven under oxygen atmosphere at 320°C for 30 minutes to obtain a coating film. The properties of the coating film were evaluated.

Example 5

On a copper plate, perfluoropolymer powder B was applied by electrostatic coating, and the coating was heated in a drying oven under oxygen atmosphere at 290°C for 30 minutes to obtain a coating film. The properties of the coating film were evaluated.

Example 6

On a copper plate, perfluoropolymer powder B was applied by electrostatic coating, and the coating was heated in a drying oven under nitrogen-purged oxygen-free atmosphere at 320°C for 30 minutes to obtain a coating film. The properties of the coating film were evaluated.

Example 7

On a copper plate, FEP primer B was applied by electrostatic coating, and the coating was heated in a drying oven under oxygen atmosphere at 290°C for 30 minutes to obtain a coating film. Further, perfluoropolymer powder B was applied by electrostatic coating, and the coating was heated in a drying oven under oxygen atmosphere at 290°C for 30 minutes to obtain a coating film. The properties of the coating film were evaluated.

Example 8

On a copper plate, FEP primer B was applied by electrostatic coating, and the coating was heated in a drying oven under nitrogen-purged oxygen-free atmosphere at 320°C for 30 minutes to obtain a coating film. Further, perfluoropolymer powder B was applied by electrostatic coating, and the coating was heated in a drying oven under oxygen-free atmosphere at 320°C for 30 minutes to obtain a coating film. The properties of the coating film were evaluated.

Example 9

On a copper plate, perfluoropolymer powder B was applied by electrostatic coating, and the coating was heated in a drying oven under nitrogen-purged oxygen-free atmosphere at 290°C for 30 minutes to obtain a coating film. The properties of the coating film were evaluated.

Example 10

On a copper plate, FEP primer B was applied by electrostatic coating, and the coating was heated in a drying oven under nitrogen-purged oxygen-free atmosphere at 290°C for 30 minutes to obtain a coating film. Further, perfluoropolymer powder B was applied by electrostatic coating, and the coating was heated in a drying oven under oxygen-free atmosphere at 290°C for 30 minutes to obtain a coating film. The properties of the coating film were evaluated.

Comparative Example 3 and Examples 11 to 17

The same operation was performed as in Comparative Example 2 and Examples 4 to 10, except that perfluoropolymer powder C (TFE/HFP/PPVE copolymer, melting point: 257°C) was used instead of perfluoropolymer powder B, and the properties of the resulting coating films were evaluated.
The results are shown in Table 1 and Table 2.

[Table 1]

| | | Comparative Example 1 | Example 1 | Example 2 | Example 3 | Comparative Example 2 | Example 4 | Example 5 | Example 6 | Example 7 | Example 8 | Example 9 | Example 10 |
|---|---|---|---|---|---|---|---|---|---|---|---|---|---|
| Perfluoropolymer | Perfluoropolymer powder A | ○ | ○ | ○ | ○ | - | - | - | - | - | - | - | - |
| | Perfluoropolymer powder B | - | - | - | - | ○ | ○ | ○ | ○ | ○ | ○ | ○ | ○ |
| | Perfluoropolymer powder C | - | - | - | - | - | - | - | - | - | - | - | - |
| Film deposition conditions | Primer application | no | yes | no | yes | no | yes | no | no | yes | yes | no | yes |
| | Film deposition temperature (°C) | 350 | 350 | 350 | 350 | 320 | 320 | 290 | 320 | 290 | 320 | 290 | 290 |
| | Heating condition | under oxygen atmosphere | under oxygen atmosphere | under oxygen-free atmosphere | under oxygen-free atmosphere | under oxygen atmosphere | under oxygen atmosphere | under oxygen atmosphere | under oxygen-free atmosphere | under oxygen atmosphere | under oxygen-free atmosphere | under oxygen-free atmosphere | under oxygen-free atmosphere |
| Coating film properties | Film thickness (μm) Primer layer | - | 50 | - | 50 | - | 50 | - | - | 50 | 50 | - | 50 |
| | Film thickness (μm) Perfluoropolymer layer | 50 | 50 | 50 | 50 | 50 | 50 | 50 | 50 | 50 | 50 | 50 | 50 |
| | Surface roughness (μm) | 0.6 | 0.6 | 0.6 | 0.5 | 0.7 | 0.7 | 1 | 0.7 | 1 | 0.6 | 1 | 0.9 |
| | Adhesion strength to substrate (N/mm) | <0.1 | 0.2 | 0.4 | 0.6 | <0.1 | 0.2 | 0.4 | 0.7 | 0.5 | 0.9 | 0.7 | 0.9 |
| | Relative dielectric constant | 2.2 | 2.4 | 2.2 | 2.4 | 2.2 | 2.3 | 2.2 | 2.2 | 2.3 | 2.3 | 2.2 | 2.3 |

[Table 2]

| | | Comparative Example 3 | Example 11 | Example 12 | Example 13 | Example 14 | Example 15 | Example 16 | Example 17 |
|---|---|---|---|---|---|---|---|---|---|
| Perfluoropolymer | Perfluoropolymer powder A | - | - | - | - | - | - | - | - |
| | Perfluoropolymer powder B | - | - | - | - | - | - | - | - |
| | Perfluoropolymer powder C | ○ | ○ | ○ | ○ | ○ | ○ | ○ | ○ |
| Film deposition conditions | Primer application | no | yes | no | no | yes | yes | no | yes |
| | Film deposition temperature (°C) | 320 | 320 | 290 | 320 | 290 | 320 | 290 | 290 |
| | Heating condition | under oxygen atmosphere | under oxygen atmosphere | under oxygen atmosphere | under oxygen-free atmosphere | under oxygen atmosphere | under oxygen-free atmosphere | under oxygen-free atmosphere | under oxygen-free atmosphere |
| Coating film properties | Film thickness (μm) Primer layer | - | 50 | - | - | 50 | 50 | - | 50 |
| | Film thickness (μm) Perfluoropolymer layer | 50 | 50 | 50 | 50 | 50 | 50 | 50 | 50 |
| | Surface roughness (μm) | 0.5 | 0.5 | 0.6 | 0.5 | 0.5 | 0.4 | 0.5 | 0.4 |
| | Adhesion strength to substrate (N/mm) | <0.1 | 0.3 | 0.5 | 0.8 | 0.7 | 1.1 | 0.8 | 1.2 |
| | Relative dielectric constant | 2.2 | 2.3 | 2.2 | 2.2 | 2.3 | 2.3 | 2.2 | 2.3 |

As shown in Table 1, the laminates in Examples were excellent in adhesion between the substrate and the coating film, with the coating film having a low surface roughness.

Example 18

On the outer periphery of a rectangular electric wire substrate of copper, FEP primer B was applied by electrostatic coating, and the coating was heated in a drying oven under nitrogen-purged oxygen-free atmosphere at 320°C for 30 minutes to obtain a coating film. Further, perfluoropolymer powder C was applied by electrostatic coating, and the coating was heated in a drying oven under oxygen-free atmosphere at 320°C for 30 minutes to obtain a coating film.
In the coating film, the primer layer had a film thickness of 50 μm, and the perfluoropolymer layer had a film thickness of 50 μm. The surface roughness was 0.7 μm and the relative dielectric constant was 2.3.
Further, the adhesion strength to the substrate was evaluated by the following procedure. Two notches with a length of 50 mm were made in approximately parallel in a long axis direction of the rectangular electric wire substrate, and at both ends thereof, one notch was made at right angle in a short axis direction, on the coating film. The notched coating film was peeled to a length of 10 cm on one end to be gripped in an upper chuck of AGS-J Autograph (50N) (manufactured by SHIMADZU CORPORATION). The conductor was fixed to the lower part to horizontalize the long face direction. Using a jig interlinkingly moving in the lateral direction corresponding to the travel distance in the vertical direction along with moving of the device in the tensile direction, the angle was adjusted such that the peeled coating film was always vertical to the conductor in the long face direction. The tensile stress during pulling at a rate of 100 mm/min until peeling to a length of 30 mm was measured, and the adhesion strength corresponding to the maximum point stress was 0.4 (N/mm).

Industrial Applicability

The laminate of the present disclosure can be suitably used for a magnet wire, a busbar, a high frequency circuit board, etc. having a substrate of copper.

## Claims

**1.** A laminate comprising a substrate containing copper and a coating film containing perfluoropolymer, having an adhesion strength between the substrate and the coating film of 0.2 N/mm or more, and a surface roughness of the coating film of less than 15 μm.

**2.** The laminate according to claim 1,
wherein the perfluoropolymer is a copolymer containing a tetrafluoroethylene (TFE) unit and at least one selected from the group consisting of a perfluoroalkyl vinyl ether (PAVE) unit and a hexafluoropropylene (HFP) unit.

**3.** The laminate according to claim 1 or 2,
wherein the perfluoropolymer is a TFE/HFP copolymer.

**4.** The laminate according to claim 2,
wherein the adhesion strength between the substrate and the coating film is 0.2 N/mm or more and 1.2 N/mm or less, and the surface roughness of the coating film is 0.1 μm or more and less than 1.5 μm.

**5.** A method of forming a laminate comprising:

coating a primer composition onto a copper-containing substrate, then applying a perfluoropolymer-containing powder composition thereon by electrostatic coating, and
heating the coating to a temperature equal to or more than the melting point of the perfluoropolymer to achieve film deposition.

**6.** A method of forming a laminate comprising:

applying a powder composition that contains a perfluoropolymer having a melting point of less than 310°C onto a copper-containing substrate by electrostatic coating, and
heating the coating to a temperature equal to or more than the melting point of the perfluoropolymer and less than 320°C to achieve film deposition.

**7.** A method of forming a laminate comprising:

applying a perfluoropolymer-containing powder composition onto a copper-containing substrate by electrostatic

coating, and
heating the coating to a temperature equal to or more than the melting point of the perfluoropolymer under oxygen-free atmosphere to achieve film deposition.

**8.** A method of forming a laminate using a combined method of forming a laminate according to two or more of claims 5 to 7.

**9.** The method of forming a laminate according to claim 5,
wherein the coating is heated to a temperature equal to or more than the melting point of the perfluoropolymer under oxygen-free atmosphere to achieve film deposition.

**10.** The method of forming a laminate according to claim 5,

wherein the powder composition that contains a perfluoropolymer having a melting point of less than 310°C is applied by electrostatic coating, and
the coating is heated to a temperature equal to or more than the melting point of the perfluoropolymer and less than 320°C under oxygen-free atmosphere to achieve film deposition.

**11.** The method of forming a laminate according to claim 6,
wherein the film deposition is achieved by heating the coating under oxygen-free atmosphere to a temperature equal to or more than the melting point of the perfluoropolymer and less than 320°C.

**12.** The method of forming a laminate according to any one of claims 5 to 11,
wherein the perfluoropolymer is a copolymer containing a tetrafluoroethylene (TFE) unit and at least one selected from the group consisting of a perfluoroalkyl vinyl ether (PAVE) unit and a hexafluoropropylene (HFP) unit.

**13.** The method of forming a laminate according to any one of claims 5, 9, 10 and 12,
wherein the primer composition comprises a perfluoropolymer as essential component and one or more resins selected from the group consisting of polyamide imide, polyether sulfone, and polyarylene sulfide.

**14.** A laminate formed by any of the methods of forming a laminate according to claims 5 to 13.

**15.** The laminate according to claim 14,
wherein the perfluoropolymer is a TFE/HFP copolymer.

**16.** An article comprising the laminate according to any one of claims 1 to 4.

**17.** A magnet wire comprising the laminate according to any one of claims 1 to 4.

**18.** A busbar comprising the laminate according to any one of claims 1 to 4.

**19.** A high frequency circuit board comprising the laminate according to any one of claims 1 to 4.

[Figure 1]

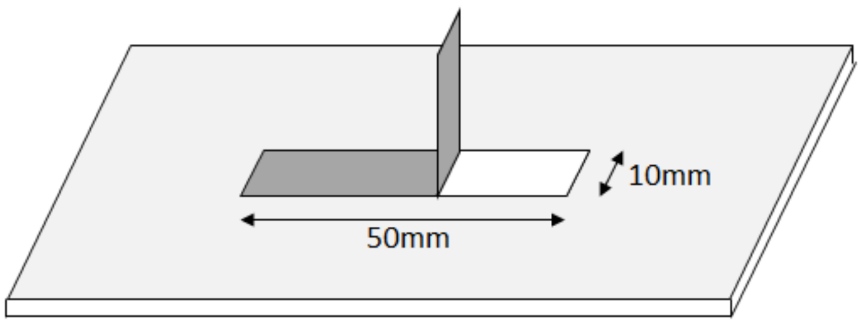

**INTERNATIONAL SEARCH REPORT**

International application No. **PCT/JP2024/043352**

**A. CLASSIFICATION OF SUBJECT MATTER**

***B32B 15/082***(2006.01)i; ***B05D 1/04***(2006.01)i; ***B05D 7/14***(2006.01)i; ***B05D 7/24***(2006.01)i; ***C08F 14/26***(2006.01)i; ***C08F 14/28***(2006.01)i; ***C08F 16/24***(2006.01)i; ***C08L 27/12***(2006.01)i; ***C08L 79/08***(2006.01)i; ***C08L 81/02***(2006.01)i; ***C08L 81/06***(2006.01)i; ***H05K 1/03***(2006.01)i

FI: B32B15/082 B; H05K1/03 630H; H05K1/03 610H; B05D7/24 302L; B05D7/14 B; C08L27/12; C08L79/08; C08L81/02; C08L81/06; C08F14/26; C08F14/28; C08F16/24; B05D1/04

According to International Patent Classification (IPC) or to both national classification and IPC

**B. FIELDS SEARCHED**

Minimum documentation searched (classification system followed by classification symbols)

B32B15/082; B05D1/04; B05D7/14; B05D7/24; C08F14/26; C08F14/28; C08F16/24; C08L27/12; C08L79/08; C08L81/02; C08L81/06; H05K1/03

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2015/111429 A1 (DAIKIN INDUSTRIES, LTD.) 30 July 2015 (2015-07-30) claims, paragraphs [0036], [0164], [0179], [0194]-[0209], examples | 1-6, 12-16 |
| Y | | 7-13, 17-19 |
| X | WO 2023/003036 A1 (DAIKIN INDUSTRIES, LTD.) 26 January 2023 (2023-01-26) claims, paragraphs [0053], [0054], [0066]-[0078], examples | 1-6, 8, 12, 14-16 |
| Y | | 7-12, 17-19 |
| X | JP 2021-062578 A (YOSHIDA SKT CO., LTD.) 22 April 2021 (2021-04-22) claims, paragraphs [0041], [0070]-[0138], examples | 1-6, 8, 12, 14-16 |
| Y | | 7-12, 17-19 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 February 2025** | **11 March 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/043352**

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 52-095780 A (MITSUI FLUOROCHEMICALS CO., LTD.) 11 August 1977 (1977-08-11)<br>claims, p. 1, right column, line 16 to p. 4, upper right column, the last line, examples | 1-4, 6-8, 12, 14-16<br>7-13, 17-19 |
| X | JP 2002-127296 A (FUJI XEROX CO., LTD.) 08 May 2002 (2002-05-08)<br>paragraph [0038] | 7, 12, 14-16 |
| Y | JP 58-030375 A (SHOWA ELECTRIC WIRE & CABLE CO.) 22 February 1983 (1983-02-22)<br>p. 1, left column, line 17 to right column, line 8 | 7-13 |
| Y | JP 2020-055241 A (AGC INC.) 09 April 2020 (2020-04-09)<br>claims, paragraph [0002] | 17-19 |
| Y | JP 2022-047366 A (SHOWA DENKO K.K.) 24 March 2022 (2022-03-24)<br>claims, paragraph [0002] | 17-19 |

Form PCT/ISA/210 (second sheet) (July 2022)

**INTERNATIONAL SEARCH REPORT**
**Information on patent family members**

International application No.
**PCT/JP2024/043352**

| Patent document cited in search report | Publication date (day/month/year) | Patent family member(s) | Publication date (day/month/year) |
|---|---|---|---|
| WO 2015/111429 A1 | 30 July 2015 | JP 2015-157474 A<br>KR 10-2016-0111452 A | |
| WO 2023/003036 A1 | 26 January 2023 | US 2024/0141195 A1<br>claims, paragraphs [0068]-[0071], [0089]-[0106], examples<br>JP 2023-16184 A<br>EP 4344871 A1<br>KR 10-2024-0010575 A<br>CN 117616092 A<br>TW 202313728 A | |
| JP 2021-062578 A | 22 April 2021 | (Family: none) | |
| JP 52-095780 A | 11 August 1977 | (Family: none) | |
| JP 2002-127296 A | 08 May 2002 | (Family: none) | |
| JP 58-030375 A | 22 February 1983 | (Family: none) | |
| JP 2020-055241 A | 09 April 2020 | (Family: none) | |
| JP 2022-047366 A | 24 March 2022 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009245857 A
- JP 2020035575 A